# EUROPEAN PATENT APPLICATION

(11) **EP 2 090 633 A1**
(43) Date of publication of application: **19.08.2009**
(21) Application number: 09152780.4
(22) Date of filing: 13.02.2009
(51) Int. Cl.: C09J 7/02

(54) **Dicing Die-Bonding Film**

(30) Priority: 18.02.2008 JP 2008036010
(71) Applicant: Nitto Denko Corporation, Ibaraki-shi, Osaka 567-8680 (JP)
(72) Inventor: Murata Shuuhei, Ibaraki-shi Osaka 567-8680 (JP); Matsumura Takeshi, Ibaraki-shi Osaka 567-8680 (JP); Kamiya Katsuhiko, Ibaraki-shi Osaka 567-8680 (JP)
(74) Representative: Sajda, Wolf E.

(57) **Abstract**

The present invention provides a dicing die-bonding film (10, 11) including a dicing film having a pressure sensitive adhesive layer (2) provided on a base material (1) and a die-bonding film (3, 3') provided on the pressure sensitive adhesive layer (2), and having excellent storage stability of a product even at room temperature. The dicing die-bonding film (10, 11) in the present invention is a dicing die-bonding film having a dicing film including a radiation curable pressure sensitive adhesive layer (2) provided onto a base material (1) and a die-bonding film (3, 3') provided on the pressure sensitive adhesive layer (2), in which a pressure sensitive adhesive in the pressure sensitive adhesive layer (2) is constituted by containing an acryl polymer, and in which the acid value of the acryl polymer is in a range of 0.01 to 1 and the iodine value is in a range of 5 to 10.

## Description

### BACKGROUND OF THE INVENTION

### Field of the Invention

The present invention relates to a dicing die-bonding film that is used for dicing a workpiece by providing an adhesive for fixing a chip-shaped workpiece (such as a semiconductor chip) and an electrode member onto the workpiece (such as a semiconductor wafer) before dicing.

### Description of the Background Art

A semiconductor wafer (workpiece) in which a circuit pattern is formed is diced into semiconductor chips (chip-shaped workpiece) (a dicing step) after the thickness thereof is adjusted as necessary by backside polishing. In the dicing step, the semiconductor wafer is generally washed with an appropriate liquid pressure (normally, about 2 kg/cm²) in order to remove a cutting layer. The semiconductor chip is then fixed onto an adherend such as a lead frame with an adhesive (a mounting step), and then transferred to a bonding step. In the mounting step, the adhesive has been applied onto the lead frame or the semiconductor chip. However, with this method, it is difficult to make the adhesive layer uniform and a special apparatus and a long period of time become necessary in the application of the adhesive. For this reason, a dicing die-bonding film is proposed that adhesively holds the semiconductor wafer in the dicing step and also imparts an adhesive layer for fixing a chip that is necessary in the mounting step (for example, see Japanese Patent Application Laid-Open JP-A-60-057 642).

The dicing die-bonding film described in JP-A-60-057 642 is composed of an adhesive layer that is formed on a supporting base material so that it can be peeled. That is, the dicing die-bonding film is made so that after the semiconductor wafer is diced while being held by the adhesive layer, the semiconductor chip is peeled together with the adhesive layer by stretching the supporting base material, the semiconductor chips are individually recovered, and then they are fixed onto an adherend such as a lead frame with the adhesive layer interposed therebetween.

Good holding power toward the semiconductor wafer so that a dicing failure, a dimensional error, etc. do not occur and good peelability in which the semiconductor chip after dicing can be peeled from the supporting base material integrally with the adhesive layer are desired for the adhesive layer of this type of the dicing die-bonding film.
However, it has been by no means easy to balance both these characteristics. Particularly, when a large holding power is required for the adhesive layer such as in the method of dicing the semiconductor wafer with a rotary round blade, it has been difficult to obtain a dicing die-bonding film that satisfies the above characteristics.

Therefore, in order to overcome such problems, various improvement methods have been proposed (for example, see JP-A-2-248 064). In this document JP-A-2-024 806, a method of interposing a pressure sensitive adhesive layer that can be cured by ultraviolet rays between the supporting base material and the adhesive layer, decreasing the adhering force between the pressure sensitive adhesive layer and the adhesive layer by curing this with ultraviolet rays after dicing, and facilitating picking up the semiconductor chip by peeling both layers is proposed.

However, in the conventional dicing die-bonding film, there is a problem that the peelability decreases with the passage of time when the dicing die-bond film is kept for a prescribed period in a condition where the dicing film and the die-bonding film are pasted together. Particularly, when it is kept at room temperature, the peelability does not sufficiently decrease even when the pressure sensitive adhesive layer is cured with ultraviolet ray radiation, and whereby a pickup failure occurs when picking up the semiconductor chip.
As a result, when keeping the conventional dicing die-bonding film for a fixed period, suppression of decreasing the peelability after curing with ultraviolet rays has been attempted such as keeping it at a low temperature.

### SUMMARY OF THE INVENTION

The present invention has been made in view of the above problems, and an object thereof is to provide a dicing die-bonding film including a dicing film having a pressure sensitive adhesive layer provided on a base material and a die-bonding film provided on the pressure sensitive adhesive layer, and having excellent storage stability of the product even at room temperature.

The inventors of the present application have investigated a dicing die-bonding film in order to solve the above conventional problems. As a result, it was found that the decrease of the peelability after curing with ultraviolet rays can be prevented even when keeping at room temperature for a prescribed period by setting the acid value and the iodine value of the acryl polymer that is a constituting material of the pressure sensitive adhesive layer, and the present invention has been achieved and completed.

That is, the dicing die-bonding film according to the present invention is a dicing die-bonding film including a dicing film having a radiation curable pressure sensitive adhesive layer on a base material and a die-bonding film provided on the pressure sensitive adhesive layer, in which a pressure sensitive adhesive in the pressure sensitive adhesive layer is constituted by containing an acryl polymer and that the acid value of the acryl polymer is in a range of 0.01 to 1 and the iodine value is in a range of 5 to 10.

The pressure sensitive adhesive layer in the dicing film of the present invention is of a radiation curable type, and an improvement of the peelability is attempted by means of decreasing the adhesive strength of the pressure sensitive adhesive layer by radiation irradiation when peeling the die-bonding film from the dicing film.
Here, the acryl polymer that is a constituting component of the pressure sensitive adhesive layer of the present invention has physical properties that the acid value is 0.01 to 1 and the iodine value is 5 to 10, and whereby the peelability of the pressure sensitive adhesive layer after radiation irradiation can be suppressed from decreasing even when keeping for a fixed period at room temperature.
That is, using the dicing die-bonding film having the above constitution, the decrease of the peelability after radiation curing can be suppressed even when keeping for a fixed period at room temperature, and the storage stability of the product becomes excellent. As a result, for example, when applying the dicing die-bonding film of the present invention to a manufacturing method of a semiconductor device, generation of pickup failures is decreased, and suppression of the yield becomes possible.

Here, the acid value means the mass of potassium hydroxide in milligrams that is required to neutralize COOH groups in 1 g of a sample. Further, the iodine value means the percentage of weight in which the weight of halogen that is absorbed when reacting halogen to the sample is converted into the weight of iodine with respect to the weight of the sample.

In the above constitution, the hydroxyl value of the acryl polymer is preferably in a range of 7 to 30. Accordingly, the decrease of the peelability after radiation curing in the pressure sensitive adhesive layer can be suppressed even more, and the yield of the semiconductor device production can be furthermore increased. Here, the hydroxyl value means the mass of potassium hydroxide in milligrams that is required to neutralize acetic acid bonding to an acetylated product obtained by reacting an acetylated agent in 1 g of a sample.

### BRIEF DESCRIPTION OF THE DRAWINGS

- Fig. 1: is a cross-sectional schematic drawing showing a dicing die-bonding film according to one embodiment of the present invention;
- Fig. 2: is a cross-sectional schematic drawing showing another dicing die-bonding film according to another embodiment of the present invention;
- Fig. 3A: is a cross-sectional schematic drawing showing an example in which a semiconductor wafer is mounted on the dicing die-bonding film with the die-bonding film interposed therebetween.
- Fig. 3B: is a cross-sectional schematic drawing showing an example in which the semiconductor wafer is diced into semiconductor chips.
- Fig. 3C: is a cross-sectional schematic drawing showing an example in which the semiconductor chip is pushed up with a needle.
- Fig. 3D: is a cross-sectional schematic drawing showing an example in which the semiconductor chip is picked up.
- Fig. 3E: is a cross-sectional schematic drawing showing an example in which the semiconductor chip is adhered and fixed to an adherent, and furthermore, the semiconductor chip is sealed with a sealing resin.

### DETAILED DESCRIPTION OF THE PREFERRED EMBODIMENTS

### Dicing Die-Bonding Film

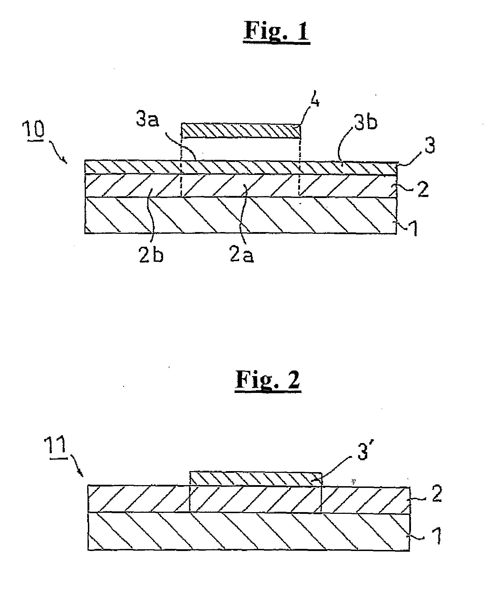

The embodiment of the present invention is described referring to Figs. 1 and 2. Fig. 1 is a cross-sectional schematic drawing showing a dicing die-bonding film according to the present embodiment. Fig. 2 is a cross-sectional schematic drawing showing another dicing die-bonding film according to the present embodiment. However, parts that are unnecessary for the description are not given, and there are parts shown by magnifying, minifying, etc. in order to make the description easy.

As shown in Fig. 1, a dicing die-bonding film 10 has a configuration having a dicing film in which a pressure sensitive adhesive layer 2 is provided on a base material 1 and a die-bonding film 3 is provided on the pressure sensitive adhesive layer 2. Further, the present invention may have a configuration in which a die-bonding film 3' is formed only in a semiconductor wafer pasting part as shown in Fig. 2

The base material 1 has radiation transparency and is a strength matrix of the dicing die-bonding films 10, 11. Examples thereof include polyolefin such as low-density polyethylene, straight chain polyethylene, intermediate-density polyethylene, high-density polyethylene, very low-density polyethylene, random copolymer polypropylene, block copolymer polypropylene, homopolypropylene, polybutene, and polymethylpentene; an ethylene-vinylacetate copolymer; an ionomer resin; an ethylene(meth)acrylic acid copolymer; an ethylene(meth)acrylic acid ester (random or alternating) copolymer; an ethylene-butene copolymer; an ethylene-hexene copolymer; polyurethane; polyester such as polyethyleneterephthalate and polyethylenenaphthalate; polycarbonate; polyetheretherketone; polyimide; polyetherimide; polyamide; whole aromatic polyamides; polyphenylsulfide; aramid (paper); glass; glass cloth; a fluorine resin; polyvinyl chloride; polyvinylidene chloride; a cellulose resin; a silicone resin; metal (foil); and paper.

Further, the material of the base material 1 includes a polymer such as a cross-linked body of the above resins. The above plastic film may be also used unstreched, or may be also used on which a monoaxial or a biaxial stretching treatment is performed depending on necessity. According to resin sheets in which heat shrinkable properties are given by the stretching treatment, etc., the adhesive area of the pressure sensitive adhesive layer 2 and the die-bonding films 3, 3' is reduced by thermally shrinking the base material 1 after dicing, and the recovery of the semiconductor chips can be facilitated.

A known surface treatment such as a chemical or physical treatment such as a chromate treatment, ozone exposure, flame exposure, high voltage electric exposure, and an ionized radiation treatment, and a coating treatment by an undercoating agent (for example, a tacky substance described later) can be performed on the surface of the base material 1 in order to improve adhesiveness, holding properties, etc. with the adjacent layer.

The same type or different type of base material can be appropriately selected and used as the base material 1, and a base material in which a plurality of types are blended can be used depending on necessity. Further, a vapor-deposited layer of a conductive substance composed of a metal, an alloy, an oxide thereof, etc. and having a thickness of about 30 to 500 Angstrom can be provided on the base material 1 in order to give an antistatic function to the base material 1. The base material 1 may be a single layer or a multi layer of two or more types.

The thickness of the base material 1 can be appropriately decided without limitation particularly. However, it is generally about 5 to 200 µm.

The pressure sensitive adhesive layer 2 is constituted by containing a radiation curable pressure sensitive adhesive. The radiation curable pressure sensitive adhesive can easily decrease its adhesive strength by increasing the degree of crosslinking by irradiation with radiation. By radiating only a part 2a corresponding to the semiconductor wafer pasting part of the pressure sensitive adhesive layer 2 shown in Fig. 2, a difference of the adhesive strength to another part 2b can be also provided. Here, the radiation includes ultraviolet ray, electron beam, etc.

Further, by curing the radiation curable pressure sensitive adhesive layer 2 with the die-bonding film 3' shown in Fig. 2, the part 2a in which the adhesive strength is remarkably decreased can be formed easily. Because the die-bonding film 3' is pasted to the part 2a in which the adhesive strength is decreased by curing, the interface of the part 2a of the pressure sensitive adhesive layer 2 and the die-bonding film 3' has a characteristic of being easily peeled during pickup. On the other hand, the part not radiated by ultraviolet rays has sufficient adhesive strength, and forms the part 2b.

As described above, in the pressure sensitive adhesive layer 2 of the dicing die-bonding film 10 shown in Fig. 1, the part 2b formed by a non-cured radiation curable pressure sensitive adhesive sticks to the die-bonding film 3, and the holding force when dicing can be secured. In such a way, the radiation curable pressure sensitive adhesive can support the die-bonding film 3 for fixing the semiconductor chip onto an adherend such as a substrate with good balance of adhesion and peeling. In the pressure sensitive adhesive layer 2 of the dicing die-bonding film 11 shown in Fig. 2, a dicing ring is fixed to the part 2b. The dicing ring made of a metal such as stainless steel or a resin can be used for example.

The radiation curable pressure sensitive adhesive that is used has a radiation curable functional group of a radical reactive carbon-carbon double bond, etc., and adherability. Examples of the radiation curable pressure sensitive adhesive are an added type radiation curable pressure sensitive adhesive in which a radiation curable monomer component or an oligomer component is compounded into an acryl pressure sensitive adhesive. The acryl pressure sensitive adhesive is a pressure sensitive adhesive having an acryl polymer as a base polymer, and it is preferable in the respect of purifying and cleaning properties, etc. of electric parts that have to be kept away from contamination such as a semiconductor wafer and a glass with ultra pure water and an organic solvent such as alcohol.

Specific examples of the acryl polymers include an acryl polymer in which acrylate is used as a main monomer component. Examples of the acrylate include alkyl acrylate (for example, a straight chain or branched chain alkyl ester having 1 to 30 carbon atoms, and particularly 4 to 18 carbon atoms in the alkyl group such as methylester, ethylester, propylester, isopropylester, butylester, isobutylester, sec-butylester, t-butylester, pentylester, isopentylester, hexylester, heptylester, octylester, 2-ethylhexylester, isooctylester, nonylester, decylester, isodecylester, undecylester, dodecylester, tridecylester, tetradecylester, hexadecylester, octadecylester, and eicosylester) and cycloalkyl acrylate (for example, cyclopentylester, cyclohexylester, etc.). These monomers may be used alone or two or more types may be used in combination.

Among the acrylates exemplified above, a monomer exemplified by a chemical formula CH₂=CHCOOR (in the formula, R is an alkyl group having 6 to 10 carbon atoms, and more preferably having 8 to 9 carbon atoms) is preferably used in the present invention. When the number of carbon atoms is less than 6, the adhesive strength becomes too large and there is a case where the pickup properties decrease. On the other hand, when the number of carbon atoms exceeds 10, the adhesiveness with the die-bonding film decreases, and as a result, there is a case where chip fly is generated when dicing.
Further, when acrylate is expressed by a chemical formula CH₂=CHCOOR, its content is preferably 50 to 91 mol% and more preferably 80 to 87 mol%, based on the entire monomer component,. When the content is less than 50 mol%, the adhesive strength becomes too large, and there is a case where the pickup properties decreases. On the other hand, when it exceeds 91 mol%, the adherability decreases, and there is a case where the chip fly is generated when dicing. Furthermore, among monomers expressed by the above chemical formula, 2-ethylhexylacrylate and isooctylacrylate are particularly preferable.

The acryl polymer contains a hydroxyl group-containing monomer copolymerizable with the acrylate as an essential component. Examples of the hydroxyl group-containing monomer include 2-hydroxyethyl(meth)aerylate, 2-hydroxypropyl(meth)acrylate, 4-hydroxybutyl(meth)acrylate, 6-hydroxyhexyl(meth)acrylate, 8-hydroxyoctyl(meth)acrylate, 10-hydroxydecyl(meth)acrylate, 12-hydroxylauryl(meth)acrylate, and (4-hydroxymethylcyclohexyl)methyl(meth)acrylate.

The content of the hydroxyl group-containing monomer is preferably in a range of 10 to 30 mol%, and more preferably in a range of 15 to 25 mol% based on the acrylate. When the content is less than 10 mol%, the crosslinking after radiation irradiation becomes insufficient, and there is a case where adhesive residue is generated to the dicing ring pasted onto the pressure sensitive adhesive layer 2 when dicing. On the other hand, when the content exceeds 30 mol%, polarity of the pressure sensitive adhesive becomes high, interaction with the die-bonding film becomes high, and therefore peeling becomes difficult.

The acryl polymer may contain a unit corresponding to other monomer components copolymerizable with the alkyl acrylate or cycloalkylester depending on necessity for the purpose of modification of cohesion force, heat resistance, etc. Examples of such monomer components include a carboxyl group-containing monomer such as acrylic acid, methacrylic acid, carboxyethyl(meth)acrylate, carboxypentyl(meth)acrylate, itaconic acid, maleic acid, fumaric acid, and crotonic acid; an acid anhydride monomer such as maleic anhydride and itaconic anhydride; a sulfonic acid group-containing monomer such as styrenesulfonic acid, allylsulfonic acid, 2-(meth)acrylartride-2-methylpropanesulfonic acid, (meth)acrylicamidepropanesulfonic acid, sulfopropyl(meth)acrylate, and (meth)acryloyloxynaphthalenesulfonic acid; a phosphoric acid containing monomer such as 2-hydroxyethylacryloylphosphate; acrylamide; and acrylonitrile. One type or two types or more of these copolymerizable monomer components can be used. The use amount of these copolymerizable monomers is preferably 40% by weight or less of the entire monomer components. However, in the case of the carboxyl group-containing monomer , an interface between the pressure sensitive adhesive layer 2 and the die-bonding film 3 disappears when the carboxyl group reacts with an epoxy group in an epoxy resin in the die-bonding film 3, and the peelability of both may decrease.
Therefore, the use amount of the carboxyl group-containing monomer is preferably 0 to 3% by weight of the entire monomer component. Additionally, because the hydroxyl group-containing monomer and a glycidyl group-containing monomer can also react with the epoxy group in the epoxy resin, the use amounts of these are preferably made to be the same as the case of the carboxyl group-containing monomer.
Further, among these monomer components, the pressure sensitive adhesive layer 2 of the present invention does not preferably contain acrylic acid. It is because the reaction and interaction between the pressure sensitive adhesive layer 2 and the die-bonding film 3 can be prevented, and even more improvement of the pickup properties can be attempted.

Here, the acryl polymer does not contain a polyfunctional monomer as the monomer component for copolymerization. Accordingly, the polyfunctional monomer does not undergo mass diffusion to the die-bonding film, and the decrease of the pickup properties caused by disappearing the interface between the pressure sensitive adhesive layer 2 and the die-bonding film 3.

Further, the acryl polymer may contain an isocyanate compound having a radical reactive carbon-carbon double bond. Examples of the isocyanate compound include methacryloylisocyanate, 2-methacryloyloxyethylisocyanate, 2-acryloyloxyethylisocyanate, and m-isopropenyl-α,α-dimethylbenzylisocyanate.

The content of the isocyanate compound is preferably in a range of 70 to 90 mol%, and more preferably in a range of 75 to 85 mol% based on the hydroxyl group-containing monomer. When the content is less than 70 mol%, the crosslinking after radiation irradiation becomes insufficient, and an adhesive residue is generated to the dicing ring pasted onto the pressure sensitive adhesive layer when dicing. On the other hand, when the content exceeds 90 mol%, polarity of the pressure sensitive adhesive becomes high, interaction with the die-bonding film becomes high, and therefore the peeling becomes difficult and the pickup properties decrease.

The acryl polymer can be obtained by polymerizing a single monomer or a monomer mixture of two or more types. The polymerization can be performed with any of methods such as solution polymerization, emulsifying polymerization, bulk polymerization, and suspension polymerization. From the viewpoint of prevention of contamination to a clean adherend, etc., the content of a low molecular weight substance is preferably small. From this viewpoint, the weight average molecular weight of the acryl polymer is preferably 350,000 to 1,000,000, and more preferably about 450,000 to 800,000. By making the weight average molecular weight 350,000 or more, the acryl polymer is prevented from becoming a low molecular weight polymer, and accordingly, for example, the generation of the peeling from the dicing ring pasted onto the pressure sensitive adhesive layer 2 when dicing can be prevented.
Furthermore, because insufficiency of the crosslinking after radiation irradiation can be prevented, the generation of an adhesive residue can also be prevented when peeling the dicing ring from the pressure sensitive adhesive layer 2. On the other hand, by making the weight average molecular weight 1,000,000 or less, workability can be improved when forming the pressure sensitive adhesive layer 2 on the base material 1.
The formation of the pressure sensitive adhesive layer 2 is performed by applying a solution of the pressure sensitive adhesive composition containing the polymer onto the base material, and then drying for example, but it is not suitable when the weight average molecular weight exceeds 1,000,000 because the viscosity of the solution of the pressure sensitive adhesive composition becomes too large, and therefore, the workability during the polymerization and the application of the polymer decreases.

The acid value of the acryl polymer of the present invention is in a range of 0.01 to 1, preferably 0.05 to 1, and more preferably in a range of 0.1 to 0.5. When the acid value is less than 0.05, there is a case where the improvement effect of tape restorability decreases. On the other hand, when the acid value exceeds 1, the adhesive strength of the dicing film to the die-bonding film becomes high, and there is a case where picking up becomes difficult. There is a case where fluidability of the pressure sensitive adhesive is spoiled.
Further, the iodine value is in a range of 5 to 10, and preferably in a range of 5.5 to 9. Further, the iodine value is less than 5, there is a case where the decrease effect of the adhesive strength after radiation irradiation becomes insufficient. On the other hand, when the iodine value exceeds 10, the adhesive strength of the dicing film to the die-bonding film becomes high, and there is a case where picking up becomes difficult.
The dicing die-bonding film of the present invention is made to be able to suppress the decrease of peelability after the ultraviolet ray irradiation of the pressure sensitive adhesive layer 2 even when it is kept at a relatively high temperature (for example, 0 °C to 40 °C) for a fixed period (for example, about 3 days to 2 weeks) by making each of the acid value and iodine value satisfy its value range at the same time. Here, the value range of the acid value is a value measured with a potentiometric titration method according to JIS K 0070-1992. Further, the value range of the iodine value is a value measured according to JIS K 0070-1992.

Furthermore, the hydroxyl value of the acryl polymer is preferably in a range of 7 to 30, and more preferably in a range of 10 to 25. When the hydroxyl value is less than 7, there is a case where the decreasing effect of the adhesive strength after radiation irradiation becomes insufficient. On the other hand, when the hydroxyl value exceeds 30, the adhesive strength of the dicing film to the die-bonding film becomes high, and there is a case where picking up becomes difficult. In the dicing die-bonding film of the present invention, the decrease of peelability after radiation curing is prevented even more by further adjusting the hydroxyl value in the value range in addition to the acid value and iodine value, and the storage stability of a product can be furthermore improved.
As a result, good pickup properties are shown even when the pickup condition (for example, the number of needles and the needle thrust-up quantity) during pickup is more challenging, and the reduction of the production yield of a semiconductor device can be attempted. Here, the value range of the hydroxyl value is a value measured with an acetylation method according to JIS K 0070-1992.

The acryl polymer shown with the acid value and iodine value in the value range can be produced with a conventionally known method such as in
JP-A- 2-187 478. At this time, the acid value can be adjusted in the value range by adjusting the copolymerization amount of acrylic acid. Further, the iodine value can be adjusted in the value range by adjusting the addition amount of 2-isocyanatoethyl(meth)acrylate. Furthermore, the hydroxyl value can be adjusted in the value range by adjusting the addition amount of 2-isocyanatoethyl(meth)acrylate and the copolymerization amount of 2-hydroxyethylacrylate.

Further, the pressure sensitive adhesive layer 2 of the present invention preferably contains a crosslinking agent having two or more functional groups showing reactivity to a hydroxyl group in the molecule. Examples of the functional group showing reactivity to a hydroxyl group include an isocyanate group, an epoxy group, and a glycidyl group. More specifically, the crosslinking agents having such an functional group include an isocyanate based crosslinking agent, an epoxy based crosslinking agent, an aziridine based crosslinking agent, and a melamine based crosslinking agent.

The isocyanate based crosslinking agent is not particularly limited as long as it has two or more isocyanate groups in the molecule, and examples include toluene diisocyanate, diphenylmethane diisocyanate, and hexamethylene diisocyanate. These may be used alone or two or more types may be used in combination.

The epoxy based crosslinking agent is not particularly limited as long as it has two or more epoxy groups in the molecule, and examples include ethylene glycol diglycidylether, sorbitol polyglycidylether, polyglycerol polyglycidylether, diglycerol polyglycidylether, glycerol polyglycidylether, and resorcine diglycidylether. These may be used alone or two or more types may be used in combination.

The aziridine based crosslinking agent is not particularly limited as long as it has two or more aziridine groups in the molecule, and examples that are preferably used include
ω-aziridinylpropionic acid-2,2-dihydroxymethyl-butanol-triester, 4,4'-bis(ethyleneiminocarbonylamino)diphenylmethane, 2,4,6-(triethyleneimino)-sym-triazine, and 1,6-bis(ethyleneiminocarbonylamino)hexane. These may be used alone or two or more types may be used in combination.

The content of the crosslinking agent is preferably in a range of 2 to 20 parts by weight , and more preferably in a range of 4 to 15 parts by weight based on 100 parts by weight of the base polymer. When the content is less than 2 parts by weight, the crosslinking after ultraviolet radiation becomes insufficient, and tensile elastic modulus decreases. As a result, an adhesive residue to the dicing ring pasted onto the pressure sensitive adhesive layer is generated when dicing the semiconductor wafer, and the pickup properties decrease when picking up the semiconductor chip because the peeling force becomes too large.
On the other hand, when the content exceeds 20 parts by weight, the tensile elastic modulus becomes too large, and as a result chip fly is generated when dicing. Here, conventionally known various additives such as a tackifier and an antioxidant may be used in the pressure sensitive adhesive other than the components depending on necessity.

Examples of the ultraviolet curable monomer component to be compounded include such as an urethane oligomer, urethane(meth)acrylate, trimethylolpropane tri(meth)acrylate, tetramethylolmethane tetra(meth)acrylate, pentaerythritol tri(meth)acrylate, pentaerythritol tetra(meth)acrylate, dipentaerythritol monohydroxypenta(meth)acrylate, dipentaerythritol hexa(meth)acrylate, and 1,4-butane dioldi(meth)acrylate. Further, the ultraviolet curable oligomer component includes various types of oligomers such as an urethane based, a polyether based, a polyester based, a polycarbonate based, and a polybutadiene based oligomer, and its molecular weight is appropriately in a range of about 100 to 30,000.
The compounding amount of the ultraviolet ray curable monomer component and the oligomer component can be appropriately determined to an amount in which the adhesive strength of the pressure sensitive adhesive layer can be decreased depending on the type of the pressure sensitive adhesive layer. Generally, it is for example 5 to 500 parts by weight, and preferably about 40 to 150 parts by weight based on 100 parts by weight of the base polymer such as an acryl polymer constituting the pressure sensitive adhesive.

Further, besides the added type radiation curable pressure sensitive adhesive described above, the radiation curable pressure sensitive adhesive includes an internal radiation curable pressure sensitive adhesive using an acryl polymer having a radical reactive carbon-carbon double bond in the polymer side chain, in the main chain, or at the end of the main chain as the base polymer. The internal ultraviolet curable pressure sensitive adhesives of an internally provided type are preferable because they do not have to contain the oligomer component, etc. that is a low molecular weight component, or most of them do not contain, they can form a pressure sensitive adhesive layer having a stable layer structure without migrating the oligomer component, etc. in the pressure sensitive adhesive over time.

Even in the case of the internal radiation curable pressure sensitive adhesive, the acid value and iodine value of the acryl polymer are in the value range. Further, specific examples of the acryl polymer are those exemplified above.

The method of introducing the radical reactive carbon-carbon double bond into the acryl polymer is not particularly limited, and various methods can be adopted. However, it is easy to introduce the radical reactive carbon-carbon double bond into the polymer side chain from the viewpoint of a molecular design. For example, a method of copolymerizing a monomer having a hydroxyl group with the acryl polymer in advance and then performing a condensation or an addition reaction on an isocyanate compound having an isocyanate group that can react with this hydroxyl group and a radical reactive carbon-carbon double bond while keeping radiation curability of the radical reactive carbon-carbon double bond.
Examples of the isocyanate compound having an isocyanate group and a radical reactive carbon-carbon double bond include those exemplified above. Further, those in which the exemplified hydroxyl group-containing monomer and an ether based compound such as 2-hydroxyethylvinylether, 4-hydroxybutylvinylether, and diethylene glycol monovinylether, etc. are copolymerized can be used as the acryl polymer.

In the internal radiation curable pressure sensitive adhesive, a base polymer (particularly, the acryl polymer) having the radical reactive carbon-carbon double bond can be used alone. However, the radiation curable monomer components or oligomer components can be also compounded to a level that does not deteriorate the characteristics. The compounding amount of the ultraviolet ray curable oligomer components, etc. is normally in a range of 0 to 30 parts by weight , and preferably in a range of 0 to 10 parts by weight based on 100 parts by weight of the base polymer.

A photopolymerization initiator is contained in the internal radiation curable pressure sensitive adhesive in the case of curing with radiation such as ultraviolet rays, Examples of the photopolymerization initiator include an α-ketol based compound such as 4-(2-hydroxyethoxy)phenyl(2-hydroxy-2-propyl)ketone, α-hydroxy-α,α'-dimethylacetophenone, 2-methyl-2-hydroxypropyophenone, and 1-hydroxycyclohexylphenylketone; an acetophenone based compound such as methoxyacetophenone, 2,2-dimethoxy-2-phenylcetophenone, 2,2-diethoxyacetophenone, and
2-methyl-1-[4-(methylthio)-phenyl]-2-morpholinopropane-1; a benzoinether based compound such as benzoinethylether, benzoinisopropylether, and anisoinmethylether; a ketal based compound such as benzyldimethylketal; an aromatic sulfonylchloride based compound such as 2-naphthalenesulfonylchloride; a photoactive oxime based compound such as 1-phenone-1,1-propanedion-2-(o-ethoxycarbonyl)oxime; a benzophenone based compound such as benzophenone, benzoylbenzoic acid and
3,3'-dimethyl-4-methoxybenzophenone; a thioxanthone based compound such as thioxanthone, 2-chlorothioxanthone, 2-methylthioxanthone, 2,4-dimethylthioxanthone, isopropylthioxanthone, 2,4-dichlorothioxanthone, 2,4-diethylthioxanthone, and 2,4-diisopropylthioxanthone; camphorquinone; halogenated ketone; acylphosphinoxide; acylphosphonate and the like. The compounding amount of the photopolymerization initiator is about 0.05 to 20 parts by weight for example based on 100 parts by weight of the base polymer such as an acryl polymer constituting the pressure sensitive adhesive.

Further, examples of the radiation curable pressure sensitive adhesive include a rubber based pressure sensitive adhesive and acryl-based pressure sensitive adhesive containing an addition polyerizable compound having two or more unsaturated bonds, a photopolymerizable compound such as alkoxysilane having an epoxy group, and a photopolymerization initiator such as a carbonyl compound, an organic sulfur compound, a peroxide, an amine salt-based and an onium salt based compound, which are disclosed in JP-A-60-196 956.

The method of forming the part 2a in the pressure sensitive adhesive layer 2 includes a method of forming the radiation curable pressure sensitive adhesive layer 2 on the base material 1 and then radiating the part 2a with radiation partially and curing. The partial radiation irradiation can be performed through a photo mask in which a pattern is formed which is corresponding to a part 3b, etc. other than the semiconductor wafer pasting part 3a.
Further, examples include a method of radiating in a spot manner and curing, etc. The formation of the radiation curable pressure sensitive adhesive layer 2 can be performed by transferring the pressure sensitive adhesive layer provided on a separator onto the base material 1. The partial radiation curing can be also performed on the radiation curable pressure sensitive adhesive layer 2 provided on the separator.

In the pressure sensitive adhesive layer 2 of the dicing die-bonding film 10, the radiation irradiation may be performed on a part of the pressure sensitive adhesive layer 2 so that the adhesive strength of the part 2a becomes smaller than the adhesive strength of other parts 2b. That is, the part 2a in which the adhesive strength is decreased can be formed by using those in which the entire or a portion of the part other than the part corresponding to the semiconductor wafer pasting part 3a on at least one face of the base material 1 is shaded, forming the radiation curable pressure sensitive adhesive layer 2 onto this, then radiating radiation, and curing the part corresponding the semiconductor wafer pasting part 3a. The shading material that can be a photo mask on a supporting film can be manufactured by printing, vapor deposition, etc. Accordingly, the dicing die-bonding film 10 of the present invention can be produced with efficiency.

Here, oxygen (air) is desirably shut off from the surface of the pressure sensitive adhesive layer 2 in the case where curing detriment due to oxygen occurs during ultraviolet ray irradiation. Examples of the method include a method of coating the surface of the pressure sensitive adhesive layer 2 with the separator and a method of performing irradiation with radiation such as ultraviolet rays in a nitrogen gas atmosphere.

Furthermore, the tensile elastic modulus of the pressure sensitive adhesive layer 2 at 23 °C before radiation irradiation is in a range of 0.4 to 3.5 MPa, and the tensile elastic modulus at 23 °C after radiation irradiation is preferably in a range of 7 to 100 MPa. By making the tensile elastic modulus (23 °C) before radiation irradiation 0.4 MPa or more, fixing of the semiconductor chip when dicing the semiconductor wafer is made to be good, and as a result, the generation of chipping can be prevented.
Further, the generation of the adhesive residue can be also prevented when peeling the dicing ring. On the other hand, by making the tensile elastic modulus (23 °C) 3.5 MPa or less, the generation of chip fly can be prevented when dicing. Further, by making the tensile elastic modulus (23 °C) after radiation irradiation 7 MPa or more, the improvement of pickup properties can be attempted.

The thickness of the pressure sensitive adhesive layer 2 is not particularly limited. However, it is preferably in the range of about 1 to 50 µm from the viewpoints of compatibility of chipping prevention of the chip cut face and holding the fixation of the adhesive layer, etc. The thickness is preferably in the range of 2 µm to 30 µm, and further preferably of 5 µm to 25 µm.

The die-bonding film 3 can have a configuration consisting of only a single layer of the adhesive layer, for example. Further, it may have a multi-layered structure of two layers or more by appropriately combining a thermoplastic resin having a different glass transition temperature and a thermosetting resin having a different heat curing temperature. Here, because cutting water is used in the dicing step of the semiconductor wafer, there is a case where the die-bonding film 3 absorbs moisture and moisture content becomes a normal condition or more.
When the die-bonding film 3 is adhered to a substrate etc. with such high moisture content, water vapor is accumulated on an adhering interface in the step after curing, and there is a case where floating is generated. Therefore, by making the adhesive for die adhering have a configuration of sandwiching a core material having high moisture permeability with a die adhesive, water vapor diffuses through the film in the step after curing, and such problem can be avoided. From such a viewpoint, the die-bonding film 3 may have a multi-layered structure in which the adhesive layer is formed on one face or both faces of the core material.

Examples of the core materials include such as a film (for example, a polyimide film, a polyester film, a polyethyleneterephthalate film, a polyethylenenaphthalate film, a polycarbonate film, etc.), a resin substrate reinforced with a glass fiber or a plastic nonwoven fiber, a silicon substrate, and a glass substrate.

The die-bonding film 3 according to the present invention is constituted by containing an epoxy resin as a main component. The epoxy resin is preferable from the viewpoint of containing fewer ionic impurities, etc. that corrode a semiconductor element. The epoxy resin is not particularly limited as long as it is generally used as an adhesive composition, and for example, a difunctional epoxy resin and a polyfunctional epoxy resin of such as a bispehnol A type, a bisphenol F type, a bisphenol S type, a brominated bisphenol A type, a hydrogenated bisphenol A type, a bisphenol AF type, a biphenyl type, a naphthalene type, a fluorine type, a phenol novolak type, an ortho-cresol novolak type, a trishydroxyphenylmethane type, and a tetraphenylolethane type epoxy resin or an epoxy resin of such as a hydantoin type, a trisglycidylisocyanurate type and a glycidylamine type epoxy resin are used.
These can be used alone or two or more types can be used in combination. Among these epoxy resins, a novolak type epoxy resin, a biphenyl type epoxy resin, a trishydroxyphenylmethane type resin, and a tetraphenylolethane type epoxy resin are particularly preferable. This is because these epoxy resins have high reactivity with a phenol resin as a curing agent, and are superior in heat resistance, etc,

Further, other thermosetting resins or thermoplastic resins can be used together in the die-bonding film 3 depending on necessity. Examples of the thermosetting resin include such as a phenol resin, an amino resin, an unsaturated polyester resin, a polyurethane resin, a silicone resin, and a thermosetting polyimide resin. These resins can be used alone or two or more types can be used in combination. Further, the curing agent of the epoxy resin is preferably a phenol resin.

Furthermore the phenol resin acts as a curing agent of the epoxy resin, and examples include a novolak type phenol resin such as a phenol novolak resin, a phenol aralkyl resin, a cresol novolak resin, a tert-butylphenol novolak resin, and a nonylphenol novolak resin; a resol type phenol resin; and polyoxystyrene such as polyparaoxystyrene. These can be used alone or two or more types can be used in combination. Among these phenol resins, a phenol novolak resin and a phenolaralkyl resin are particularly preferable. This is because connection reliability of the semiconductor device can be improved.

The compounding ratio of the epoxy resin and the phenol resin is preferably made, for example, such that the hydroxy group in the phenol resin becomes 0.5 to 2.0 equivalent per equivalent of epoxy group in the epoxy resin component. It is more preferably 0.8 to 1.2 equivalent. That is, when the both compounding ratio becomes outside of the range, a sufficient curing reaction does not proceed, and the characteristics of the epoxy resin cured product easily deteriorate.

Examples of the thermoplastic resin include a natural rubber, a butyl rubber, an isoprene rubber, a chloroprene rubber, an ethylene-vinylacetate copolymer, an ethylene-acrylic acid copolymer, an ethylene-acrylate copolymer, a polybutadiene resin, a polycarbonate resin, a thermoplastic polyimide resin, a polyamide resin such as 6-nylon and 6,6-nylon, a phenoxy resin, an acrylic resin, a saturated polyester resin such as PET and PBT, a polyamideimide resin, and a fluorine resin. These thermoplastic resins can be used alone or two type or more can be used in combination. Among these thermoplastic resins, the acrylic resin is particularly preferable in which the ionic impurities are less, the heat resistance is high, and reliability of the semiconductor element can be secured.

The acrylic resin is not particularly limited, and examples include such as polymers having one type or two types or more of acrylic acid or methacrylic ester having a straight chain or branched alkyl group having 30 or more carbon atoms, particularly 4 to 18 carbon atoms as a component. Examples of the alkyl group include a methyl group, an ethyl group, a propyl group, an isopropyl group, an n-butyl group, a t-butyl group, an isobutyl group, an amyl group, an isoamyl group, a hexyl group, a heptyl group, a cyclohexyl group, a 2-ethylhexyl group, an octyl group, an isooctyl group, a nonyl group, an isononyl group, a decyl group, an isodecyl group, an undecyl group, a lauryl group, a tridecyl group, a tetradecyl group, a stearyl group, an octadecyl group, and a dodecyl group.

Further, other monomers forming the polymers are not particularly limited, and examples include a carboxyl group-containing monomer such as acrylic acid, methacrylic acid, carboxylethylacrylate, carboxylpentylacrylate, itaconic acid, maleic acid, fumaric acid, and chrotonic acid; an acid anhydride monomer such as maleic anhydride and itaconic anhydride; a hydroxyl group-containing monomer such as 2-hydroxyethyl(meth)acrylate, 2-hydroxypropyl(meth)acrylate, 4-hydroxybutyl(meth)acrylate, 6-hydroxyhexyl(meth)acrylate, 8-hydroxyoctyl(meth)acrylate, 10-hydroxydecyl(meth)acrylate, 12-hydroxylauryl(meth)acrylate, and (4-hydroxymethylcyclohexyl)-methylacrylate; a sulfonic acid-containing monomer such as styrenesulfonic acid, allylsulfonic acid, 2-(meth)acrylamide-2-methylpropanesulfonic acid, (meth)acrylamidepropane sulfonic acid, sulfopropyl(meth)acrylate, and (meth)acryloyloxynaphthalene sulfonic acid; and a phosphoric acid-containing monomer such as 2-hydroxyethylacryloylphosphate.

Because the crosslinking is performed in the adhesive layer of the die-bonding film 3 to some extent in advance, a polyfunctional compound that reacts with a functional group in the end of molecular chain of the polymer is preferably added as a crosslinking agent when producing. Accordingly, the adhesive characteristic under high temperature is improved, and the improvement of the heat resistance is attempted.

Here, other additives can be appropriately compounded in the adhesive layer of the die-bonding film 3 depending on necessity. Examples of the other additives include a flame retardant, a silane coupling agent, and an ion trapping agent. Examples of the flame retardant include antimony trioxide, antimony pentoxide, a brominated epoxy resin. These can be used alone or two or more types can be used in combination. Examples of the silane coupling agent include β-(3,4-epoxycyclohexyl)ethyltrimethoxysilane, γ-glycidoxypropyltrimethoxysilane, and γ-glycidoxypropylmethyldiethoxysilane. These compounds can be used alone or two or more types can be used in combination. Examples of the ion trapping agents include hydrotalcites and bismuth hydroxide. These can be used alone or two or more types can be used in combination.

The thickness of the die-bonding film 3 is not particularly limited. However, it is about 5 to 100 µm, and preferably about 5 to 50 µm.

The dicing die-bonding films 10, 11 can be made to have an antistatic function. Accordingly, the circuit can be prevented from breaking down due to the generation of electrostatic energy during adhesion and peeling thereof and charging of a workpiece (a semiconductor wafer, etc.) by electrostatic energy or the like. Imparting the antistatic function can be performed with an appropriate manner such as a method of adding an antistatic agent or a conductive substance to the base material 1, the pressure sensitive adhesive layer 2, and the die-bonding film 3 and providing of a conductive layer composed of a charge-transfer complex, a metal film, etc. to the base material 1.
These methods are preferably a method of which an impurity ion is difficult to generate, having fear of changing quality of the semiconductor wafer. Examples of the conductive substance (conductive filler) to be compounded for the purpose of imparting conductivity, improving thermal conductivity, etc. include a sphere-shaped, a needle-shaped, a flake-shaped metal powder such as silver, aluminum, gold, copper, nickel, and conductive alloy; a metal oxide such as alumina; amorphous carbon black, and graphite. However, the die-bonding films 3, 3' are preferably non-conductive from the viewpoint of having no electric leakage.

The die-bonding films 3, 3' of the dicing die-bonding films 10, 11 are preferably protected by a separator (not shown). The separator has a function as a protecting material that protects the die-bonding films 3, 3' until they are practically used. Further, the separator can be used as a supporting base material when transferring the die-bonding films 3, 3' to the pressure sensitive adhesive layer 2. The separator is peeled when pasting a workpiece onto the die-bonding films 3, 3' of the dicing die-bonding film. Polyethylenetelephthalate (PET), polyethylene, polypropylene, a plastic film, a paper, etc. whose surface is coated with a peeling agent such as a fluorine based peeling agent and a long chain alkylacrylate based peeling agent can be also used as the separator.

### Producing Method of Dicing Die-bonding Film

Next, the producing method of the dicing die-bonding film of the present invention is described with the dicing die-bonding film 10 as an example. First, the base material 1 can be formed with a conventionally known film producing method. Examples of the film-forming method include such as a calendar film-forming method, a casting method in an organic solvent, an inflation extrusion method in a closely sealed system, a T-die extrusion method, a co-extruding method, and a dry laminating method.

Next, the pressure sensitive adhesive layer 2 is formed by applying a composition containing the pressure sensitive adhesive on the base material 1 and drying (crosslinking by heat depending on necessity). Examples of the application manner include such as roll coating, screen coating, and gravure coating. Further, the application may be performed directly on the base material 1, or a peeling paper, etc. whose surface has been subjected to a peeling treatment is applied and then transferred onto the base material 1.

Next, an application layer is formed by applying a forming material for forming the die-bonding film 3 onto the peeling paper so as to have a prescribed thickness and furthermore drying under a prescribed condition. The die-bonding film 3 is formed by transferring this application layer onto the pressure sensitive adhesive layer 2. Further, the die-bonding film 3 can be also formed also by directly applying the forming material on the pressure sensitive adhesive layer 2 and then drying under a prescribed condition. Accordingly, the dicing die-bonding film 10 according to the present invention can be obtained.

### Producing Method of Semiconductor Device

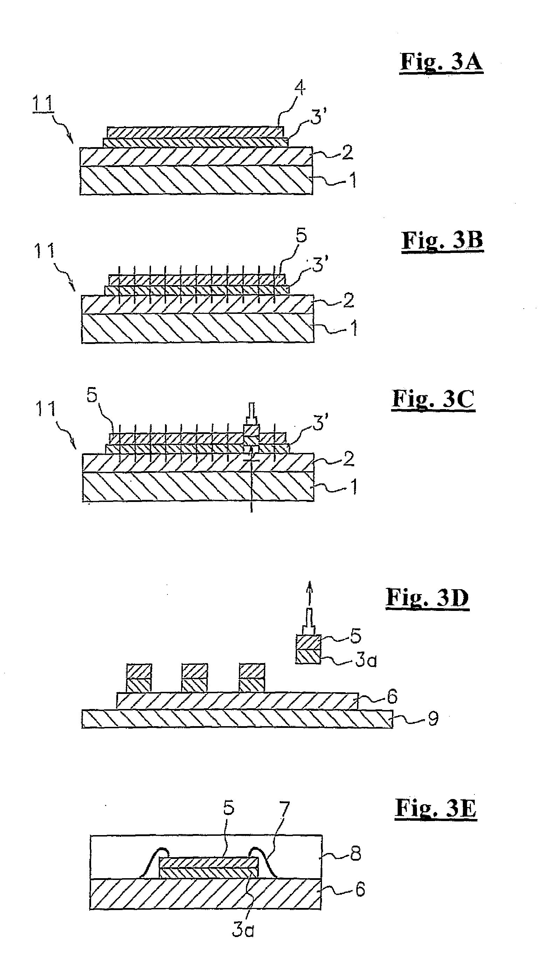

The dicing die-bonding films 10, 11 of the present invention are used as follows by appropriately peeling the separator arbitrarily provided on the die-bonding films 3, 3'. Hereinbelow, referring to Figs. 3A to 3E, it is described while using the dicing die-bonding 11 as an example.

First, a semiconductor wafer 4 is press-adhered on the die-bonding film 3' in the dicing die-bonding film 11, and it is fixed by adhering and holding (mounting step). The present step is performed while pressing with a pressing means such as a pressing roll.

Next, the dicing of the semiconductor wafer 4 is performed. Accordingly, the semiconductor wafer 4 is cut into a prescribed size and individualized, and a semiconductor chip is produced. The dicing is performed following a normal method from the circuit face side of the semiconductor wafer 4, for example. Further, the present step can adopt such as a cutting method called full-cut that forms a slit in the dicing die-bonding film 10. The dicing apparatus used in the present step is not particularly limited, and a conventionally known apparatus can be used. Further, because the semiconductor wafer is adhered and fixed by the dicing die-bonding film 10, chip crack and chip fly can be suppressed, and at the same time the damage of the semiconductor wafer can be also suppressed.

Pickup of the semiconductor chip 5 is performed in order to peel a semiconductor chip that is adhered and fixed to the dicing die-bonding film 10. The method of picking up is not particularly limited, and conventionally known various methods can be adopted. Examples include a method of pushing up the individual semiconductor chip 5 from the dicing die-bonding 10 side with a needle and picking up the pushed semiconductor chip 5 with a picking-up apparatus.

Here, the picking up is performed after radiating the pressure sensitive adhesive layer 2 with ultraviolet rays because the pressure sensitive adhesive layer 2 is an ultraviolet curable type pressure sensitive adhesive layer. Accordingly, the adhesive strength of the pressure sensitive adhesive layer 2 to the die-bonding film 3a decreases, and the peeling of the semiconductor chip 5 becomes easy.
As a result, picking up becomes possible without damaging the semiconductor chip. The condition such as irradiation intensity and irradiation time when irradiating an ultraviolet ray is not particularly limited, and it may be appropriately set depending on necessity. Further, the light source as described above can be used as a light source used in the ultraviolet irradiation.

The semiconductor chip 5 picked up is adhered and fixed to an adherend 6 through the die-bonding film 3a interposed therebetween (die bonding). The adherend 6 is mounted onto a heat block 9. Examples of the adherend 6 include such as a lead frame, a TAB film, a substrate, and a semiconductor chip separately produced. The adherend 6 may be a deformable adherend that are easily deformed, or may be a non-deformable adherend (a semiconductor wafer, etc.) that is difficult to deform, for example.

A conventionally known substrate can be used as the substrate. Further, a metal lead frame such as a Cu lead frame and a 42 Alloy lead frame and an organic substrate composed of glass epoxy, BT (bismaleimide-triazine), and polyimide can be used as the lead frame. However, the present invention is not limited to this, and includes a circuit substrate that can be used by mounting a semiconductor element and electrically connecting with the semiconductor element.

When the die-bonding film 3 is a thermosetting type die-bonding film, the semiconductor chip 5 is adhered and fixed onto the adherend 6 by heat-curing to improve the heat resistance strength. Here, a product in which the semiconductor chip 5 is adhered and fixed onto a substrate etc. through the semiconductor wafer pasting part 3a interposed therebetween can be subjected to a reflow step.
After that, wire bonding is performed by electrically connecting the tip of a terminal part (inner lead) of the substrate and an electrode pad (not shown) on the semiconductor chip 5 with a bonding wire 7, and furthermore, the semiconductor chip is sealed with a sealing resin 8, and the sealing resin 8 is cured. Accordingly, the semiconductor device according to the present embodiment is manufactured.

The preferred examples of this invention are illustratively described in detail hereinbelow. However, the materials, the compounding amount, etc. described in these examples are not intended to limit the scope of this invention to these only unless otherwise stated, and they are only explanatory examples. Further, part in each example is a weight standard unless otherwise stated.

### EXAMPLE 1

### Manufacture of Dicing Film

An acryl polymer A having a weight average molecular weight of 850,000 was obtained by charging 88.8 parts of 2-ethylhexylacrylate (hereinbelow, refers to as "2EHA"), 11.2 parts of 2-hydroxyethylacrylate (hereinbelow, referred to as "HEA"), 0.2 parts of benzoylperoxide, and 65 parts of toluene into a reactor equipped with a condenser, a nitrogen introducing pipe, a thermometer, and a stirring apparatus, and performing a polymerization process at 61 °C for 6 hours in a nitrogen flow. The weight average molecular weight is as described below. The molar ratio of 2EHA and HEA was made to be 100 mol to 20 mol.

An acryl polymer A' was obtained by adding 12 parts of 2-methacryloyloxyethylisocyanate (hereinbelow, referred to as "MOI") (80 mol% to HEA) to the acryl polymer A and performing an addition reaction process at 50 °C for 48 hours in an air flow. The acid value, the hydroxyl value, and the iodine value of the acryl polymer A' measured with the method described later were 0.25, 16, and 6.4, respectively.

Next, a pressure sensitive adhesive solution was manufactured by adding 8 parts of a polyisocyanate compound (trade name: COLONATE L, manufactured by Nippon Polyurethane Industry Co., Ltd.) and 5 parts of a photopolymerization initiator (trade name: IRUGACURE 651, manufactured by Ciba) based on 100 parts of the acryl polymer A' .

A pressure sensitive adhesive layer having a thickness of 10 µm was formed by applying the pressure sensitive adhesive solution prepared above onto the surface of a PET peeling liner where a silicone treatment was performed and heat-crosslinking was performed at 120 °C for 2 minutes. Then, a polyolefin film having a thickness of 100 µm was pasted onto the surface of the pressure sensitive adhesive layer. After that, it was kept at 50 °C for 24 hours, and then the dicing die-bonding film according to the present example was manufactured.

### Manufacture of Die-Bonding Film

59 parts of an epoxy resin 1 (trade name: EPICOAT 1004, manufactured by Japan Epoxy Resins Co., Ltd.), 53 parts of an epoxy resin 2 (trade name: EPICOAT 827, manufactured by Japan Epoxy Resins Co., Ltd.), 121 parts of a phenol resin (trade name: MILEX XLC-4L, manufactured by Mitsui Chemicals, Inc.), 222 parts of sphere silica (trade name: SO-25R, manufactured by Admatechs Co., Ltd.) based on 100 parts of an acrylate polymer (trade name: PARACRON W-197CM, manufactured by Negami Chemical Industrial Co., Ltd.) having ethylacrylate-methylmethacrylate as the main component were dissolved into methyethylketone, and prepared so that the concentration became 23.6 % by weight.

A solution of this adhesive composition was applied onto a mold release treated film composed of a polyethylene terephthalate film having a thickness of 38 µm in which a silicone mold release treatment was performed as the peeling liner (separator), and then dried at 130 °C for 2 minutes. Accordingly, a die-bonding film having a thickness of 25 µm was manufactured. Furthermore, the dicing die-bonding film according to the present example was obtained by transferring the die-bonding film to the pressure sensitive adhesive layer side in the dicing film described above.

### Measurement of Weight Average Molecular Weight Mw

The measurement of the weight average molecular weight Mw was performed by GPC (gel permeation chromatography). The measurement condition is as follows. Here, the weight average molecular weight was calculated in terms of polystyrene.

| | |
|---|---|
| Measurement apparatus : | HLC-8120GPC (product name, manufactured by |
| | Tosoh Corporation) |
| Column : | TSK gel GMH-H (S) x 2 (product number, manufactured by Tosoh Corporation |
| | manufactured by Tosoh Corporation) |
| Flow rate: | 0.5 ml/min |
| Injection rate: | 100 µl |
| Column temperature: | 40 °C |
| Eluent: | THF |
| Injection sample concentration: | 0.1 % by weight |
| Detector: | a differential refractometer. |

### Measurement of Acid Value

The acid value of the acryl polymer A' was evaluated according to JIS K 0070-1992 (a potentiometric titration method). That is, 100 ml of acetone was added to about 3 g of the dried acryl polymer A', and dissolved with stirring. 25 ml of water was added thereto and the mixture was stirred. Titration of this solution was performed with 0.05 mol/l of a sodium hydroxide solution. The mg of potassium hydroxide that is necessary to neutralize 1 g of the sample was expressed as the acid value.

### Measurement of Hydroxyl value

The hydroxyl value of the acryl polymer A' was evaluated according to JIS K 0070-1992 (an acetylation method). That is, 10 ml of an acetylation reagent was charged into about 3 g of the dried acryl polymer A', and 30 ml of pyridine and 30 ml of dimethylformamide were added as a solvent. This solution was heated in a water bath (95 to 100°C) equipped with a condenser for 1 hour and 30 minutes. Furthermore, after adding 3 ml of water, it was heated for 10 minutes.

After that, it was cooled to room temperature, and the condenser was washed with 5 ml of ethanol and the ethanol was added. A stirrer is placed in this solution, and while stirring with a magnetic stirrer, titration was performed with 0.5 mol/l of a sodium hydroxide solution using a potentiometric titration apparatus. The amount in mg of potassium hydroxide that is necessary to neutralize acetic acid bonding to the hydroxy group when 1 g of the sample is acetylated is expressed as the hydroxyl value.

### Measurement of Iodine Value

The iodine value of the acryl polymer A' was evaluated according to JIS K 0070-1992. That is, 30 ml of chloroform was added to about 3 g of the dried acryl polymer A' to be dissolved. 25 ml of a Wijs liquid was added thereto and the mixture was stirred. After that, it was plugged in a closely sealed state and left at 23 °C in a dark place for 1 hour. 20 ml of a potassium iodide solution and 100 ml of water were added thereto and the mixture was stirred.
Titration of this solution was performed with 0.1 mol/l of a sodium thiosulfate solution, and when the solution became slightly yellow, a starch solution was added dropwise and the titration was performed until a blue color disappeared. The value at which an amount of halogen that bonds when halogen is reacted with 100 g of the sample is converted into g of iodine is expressed as the iodine value.

### EXAMPLES 2 to 9

A dicing die-bonding film was manufactured in each of Examples 2 to 9 in the same manner as in the Example 1 except that the composition and the content were changed to the values shown in Table 1 below.

### COMPARATIVE EXAMPLES 1 to 4

A dicing die-bonding film was manufactured in each of comparative examples 1 to 4 in the same manner as in the Example 1 except that the composition and the content were changed to the values shown in Table 1 below.

**Table 1**

| | Hydroxyl value | Acid value | Iodine value | Acrylate | Hydroxyl group-containing mononer | AA | Isocyanate Compound | Toluene | C / L | Photopoly-merization Initiator |
|---|---|---|---|---|---|---|---|---|---|---|
| | | | | 2EHA | HEA | | MOI | | | |
| Example 1 | 16 | 0.25 | 6.4 | 88.8 (100) | 11.2 (20) | - | 12.0 (80) | 65 | 8 | 5 |
| Example 2 | 14 | 0.38 | 9.3 | 84.1 (100) | 15.9 (30) | - | 18.4 (87) | 65 | 8 | 5 |
| Example 3 | 28 | 0.32 | 6.3 | 87.3 (100) | 12.7 (23) | - | 11.8 (70) | 65 | 8 | 5 |
| Example 4 | 8 | 0.22 | 6.4 | 89.8 (100) | 10.2 (18) | - | 12.1 (89) | 65 | 8 | 5 |
| Example 5 | 21 | 0.21 | 5.3 | 89.8 (100) | 10.2 (18) | - | 9.8 (72) | 65 | 8 | 5 |
| Example 6 | 16 | 0.45 | 6.4 | 88.8 (100) | 11.2 (20) | 0.03 (0.1) | 12.0 (80) | 65 | 8 | 5 |
| Example 7 | 16 | 0.91 | 6.4 | 88.7 (100) | 11.2 (20) | 0.10 (0.3) | 12.0 (80) | 65 | 8 | 5 |
| Example 8 | 4 | 0.30 | 7.4 | 88.8 (100) | 11.2 (20) | - | 15.0 (100) | 65 | 8 | 5 |
| Example 9 | 87 | 0.32 | 5.8 | 79.9 (100) | 20.1 (40) | - | 10.8 (40) | 65 | 8 | 5 |
| Comparative Example 1 | 18 | 0.20 | 2.3 | 94.6 (62.5) | 5.4 (9) | - | 4.0 (56) | 65 | 8 | 5 |
| Comparative Example 2 | 10 | 0.34 | 11.9 | 79.9 (100) | 20.1 (40) | - | 24.9 (93) | 65 | 8 | 5 |
| Comparative Example 3 | 16 | 11.0 | 6.3 | 87.3 (100) | 11.0 (20) | 1.7 (5) | 11.8 (80) | 65 | 8 | 5 |
| Comparative Example 4 | 16 | 2.90 | 6.4 | 88.4 (100) | 11.0 (20) | 0.4 (1.2) | 11.9 (80) | 65 | 8 | 5 |

| | | | | | | | | | | |
|---|---|---|---|---|---|---|---|---|---|---|
| Please note: Values in parentheses represent mol. However, a value in parentheses in MOI represents a molar ratio to HEA. | | | | | | | | | | |

Here, meanings of the abbreviations described in Table 1 are as follows. 2EHA: 2-ethylhexylacrylate HEA: 2-hydroethylacrylate AA: Acrylic acid MOI: 2-methacryloyloxyethylisocyanate C/L: a polyisocyanate compound (trade name: COLONATE L, manufactured by Nippon Polyurethane Industry Co., Ltd.)

### Dicing

Using each of dicing die-bonding films of the Examples and Comparative Examples, dicing of a semiconductor wafer was actually performed in a manner described below, and performance of each dicing die-bonding film was evaluated.

The backside of a semiconductor wafer (diameter 8 inches, thickness 0.6 mm) was polished, and a mirror wafer having a thickness of 0.15 mm was used as a workpiece. After peeling the separator from the dicing die-bonding film, a mirror wafer was pasted onto the die-bonding film by roll pressing at 40 °C, and dicing was furthermore performed. Further, the dicing was performed in full cut so that the chip size became 1 mm square.
Whether there is chip fly or not was confirmed for the semiconductor wafer and the dicing die-bonding film after cutting. For chip fly, the case where even one semiconductor chip flies was made to be ×, and the case where they did not fly was made to be ○. The wafer grinding condition, the pasting condition, and the dicing condition are described later.

### Wafer Grinding Condition

Grinding apparatus: DFG-8560 manufactured by DISCO Corporation Semiconductor wafer: 8 inch diameter (backside was ground so as to be a thickness of 0.6 mm to 0.15 mm)

### Pasting Condition

Pasting apparatus: MA-300011 manufactured by Nitto Seiki Co., Ltd. Pasting speed: 10 mm/min Pasting pressure: 0.15 MPa Stage temperature when pasting: 40 °C

### Dicing Condition

Dicing apparatus: DFD-6361 manufactured by DISCO Corporation Dicing ring: 2-8-1 (manufactured by DISCO Corporation) Dicing speed: 80 mm/sec Dicing blade:
Z1; 2050HEDD manufactured by DISCO Corporation
Z2; 2050HEBB manufactured by DISCO Corporation
   Dicing blade rotation speed:
Z1; 40,000 rpm
Z2; 40,000 rpm
   Blade height:
Z1; 0.215 mm (depending on the thickness of the semiconductor wafer (0.170 mm when the thickness of the wafer is 75 µm))
Z2; 0.085 mm
   Cutting method: A mode / step cut
   Wafer chip size: 1.0 mm square

### Pickup

Using each of the dicing die-bonding films of the Examples and Comparative Examples, pickup was performed after dicing of the semiconductor wafer was actually performed in a manner described below, and performance of each dicing die-bonding film was evaluated.

The backside of a semiconductor wafer (diameter 8 inches, thickness 0.6 mm) was polished, and a mirror wafer having a thickness of 0.075 mm was used as a workpiece. After pasting the dicing film and the die-bonding film, it was left at 23 °C for 1 hour. After that, the separator on the adhesive layer in the die-bonding film was peeled and the mirror wafer was pasted onto the die-bonding film by roll pressing at 40 °C. Furthermore, after leaving at 23 °C for 1 hour, dicing of the mirror wafer was performed. The dicing was performed in full cut so that the chip size became 10 mm square.

Next, an expanding step was performed of making intervals between chips by performing ultraviolet ray irradiation to each dicing die-bonding film and stretching them. Furthermore, the pickup properties were evaluated by picking up a semiconductor chip from the base material side of each dicing die-bonding film with a pushing up method by a needle.
Specifically, 400 semiconductor chips were picked up continuously, the case where both success rates when performing with conditions A and B described later were 100 % was made to be ⊙, the case where the success rate when performing with condition A is 100 % and the success rate when performing with condition B was not 100 % was made to be ○, and the case where both success rates when performing with conditions A and B were not 100 % was made to be ×.

### Wafer Grinding Condition

Grinding apparatus: DFG-8560 manufactured by DISCO Corporation Semiconductor wafer: 8 inch diameter (backside was ground so as to be a thickness of 0.6 mm to 0.075 mm)

### Pasting Condition

Pasting apparatus: MA-3000II manufactured by Nitto Seiki Co., Ltd. Pasting speed: 10 mm/min Pasting pressure: 0.15 MPa Stage temperature when pasting: 40°C

### Dicing Condition

Dicing apparatus: DFD-6361 manufactured by DISCO Corporation Dicing ring: 2-8-1 (manufactured by DISCO Corporation) Dicing speed: 80 mm/sec Dicing blade:
Z1; 2050HEDD manufactured by DISCO Corporation
Z2; 2050HEBB manufactured by DISCO Corporation

Dicing blade rotation speed:
Z1; 40,000 rpm
Z2; 40,000 rpm

Blade height:
Z1; 0.0170 mm (depending on the thickness of the semiconductor wafer (0.170 mm when the thickness of the wafer is 75 µm))
Z2; 0.085 mm
   Cutting method: A mode / step cut
   Wafer chip size: 10.0 mm square

### Irradiation Condition of Ultraviolet Rays

Ultraviolet ray (UV) irradiation apparatus: UM-810 (trade name, manufactured by Nitto Seiki Co., Ltd.) Ultraviolet ray irradiation integrated amount of light: 300 mJ/cm² Here, the ultraviolet ray irradiation was performed from the polyolefin film side.

### Pickup Condition

Each pickup was performed in a condition A and a condition B shown in the following Table 2.

**Table 2**

| | Condition A | Condition B |
|---|---|---|
| Needle | Total length: 1 0 mm, Diameter:0.7 mm, Acute angle:15 edg, Tip:R350 µm | Same as on the left |
| Number of Needles (Needles) | 9 | 5 |
| Needle Pushing-up Amount (µm) | 350 | 250 |
| Needle Pushing-up Speed (mm/sec) | 5 | 5 |
| Collet Retention Time (msec) | 200 | 200 |
| Expand (mm/sec) | 3 | 3 |

### Storage Stability Test 1

The dicing die-bonding film in which the dicing film and the die-bonding film were pasted together was stored at 0 °C for 2 weeks (relative humidity %). After that, the pickup was evaluated in the same condition as described above. The case where both success rates when performing with conditions A and B were 100 % was made to be ⊙, the case where the success rate when performing with condition A is 100% and the success rate when performing with condition B was not 100 % was made to be ○, and the case where both success rates when performing with conditions A and B were not 100 % was made to be ×.

### Storage Stability Test 2

The pickup was evaluated in the same manner as the storage stability test 1 except that the temperature of the storage period was changed to 23 °C. The result is shown in Table 3.

### Storage Stability Test 3

The pickup was evaluated in the same manner as in the storage stability test 1 except that the temperature of the storage period was changed to 40°C. The result is shown in Table 3.

### Measurement of Tensile Elastic Modulus

A tensile test was performed in an MD direction or a TD direction on a sample having a size of initial length 10 mm and a cross sectional area of 0.1 to 0.5 mm² with a measurement condition having a measurement temperature of 23°C, a distance between chucks of 50 mm, and a tensile speed of 50 mm/min, and the changed amount (mm) of stretching of the sample in each direction was measured. As a result, the tensile elastic modulus was obtained by drawing a tangent in a part of the initial rise-up of the obtained S-S curve, dividing the tensile strength when the tangent corresponds to 100 % stretch by the cross-section of the base material film. Here, the measurement of the tensile elastic modulus after ultraviolet ray irradiation was performed after radiating ultraviolet rays from the polyolefin film side with the irradiation condition.

### Adhesive residue of Dicing Ring

The dicing film was peeled from the dicing ring, and whether the adhesive residue was generated or not in the dicing ring was confirmed visually. The dicing ring in which the adhesive residue was confirmed was made to be ×, and in which it was not confirmed was made to be ○.

**Table 3**

| | Mw (x 10⁴) | Tensile Elastic Modulus (MPa) | Tensile Elastic Modulus After UV Curing (MPa) | Evaluation Result | | | | | |
|---|---|---|---|---|---|---|---|---|---|
| | | | | Pickup Property | Storage Stability Test 1 | Storage Stability Test 2 | Storage Stability Test 3 | Chip Fly | Remaining of Bond to Dicing Ring |
| Example 1 | 58 | 1.0 | 19.7 | ⊙ | ⊙ | ⊙ | ⊙ | ○ | ○ |
| Example 2 | 62 | 1.7 | 90.1 | ⊙ | ⊙ | ⊙ | ⊙ | ○ | ○ |
| Example 3 | 59 | 1.0 | 15.2 | ⊙ | ⊙ | ⊙ | ⊙ | ○ | ○ |
| Example 4 | 58 | 1.1 | 21.8 | ⊙ | ⊙ | ⊙ | ⊙ | ○ | ○ |
| Example 5 | 58 | 1.0 | 17.0 | ⊙ | ⊙ | ⊙ | ⊙ | ○ | ○ |
| Example 6 | 58 | 1.0 | 19.7 | ⊙ | ⊙ | ⊙ | ⊙ | ○ | ○ |
| Example 7 | 60 | 1.0 | 19.9 | ⊙ | ⊙ | ⊙ | ○ | ○ | ○ |
| Example 8 | 59 | 0.8 | 22.0 | ○ | ○ | ○ | ○ | ○ | ○ |
| Example 9 | 62 | 1.9 | 25.6 | ○ | ○ | ○ | ○ | ○ | ○ |
| Comparative Example 1 | 55 | 0.7 | 8.4 | × | × | × | × | ○ | × |
| Comparative Example 2 | 63 | 2.2 | 115 | ○ | ○ | × | × | ○ | ○ |
| Comparative Example 3 | 65 | 1.3 | 23.2 | × | × | × | × | ○ | × |
| Comparative Example 4 | 61 | 1.1 | 21.1 | ⊙ | ○ | × | × | ○ | ○ |

### List of Reference Signs

- 1 =: base material
- 2 =: pressure sensitive adhesive layer
- 2a =: part
- 2b =: part
- 3, 3' =: die-bonding film
- 3a =: wafer pasting part
- 3b =: part
- 4 =: semiconductor wafer
- 5 =: semiconductor chip
- 6 =: adherend
- 7 =: bonding wire
- 8 =: sealing resin
- 9 =: heat block
- 10 =: die-bonding film
- 11 =: die-bonding film

## Claims

1. A dicing die-bonding film comprising a dicing film having a radiation curable pressure sensitive adhesive layer (2) provided on a base material
(1) and a die-bonding film (3, 3') provided on the pressure sensitive adhesive layer (2), wherein a pressure sensitive adhesive in the pressure sensitive adhesive layer (2) is constituted by containing an acryl polymer, and
wherein the acid value of the acryl polymer is in a range of 0.01 to 1 and the iodine value is in a range of 5 to 10.

2. The dicing die-bonding film according to claim 1,
wherein the hydroxyl value of the acryl polymer is in a range of 7 to 30.

3. The dicing die-bonding film according to claim 1 or 2,
wherein the acryl polymer includes an acryl polymer in which acrylate is used as a main monomer component.

4. The dicing die-bonding film according to claim 3,
wherein the acrylate is a monomer exemplified by a chemical formula CH₂=CHCOOR (in the formula, R is an alkyl group having 6 to 10 carbon atoms).

5. The dicing die-bonding film according to claim 4,
wherein the content of the monomer exemplified by a chemical formula CH₂=CHCOOR (in the formula, R is an alkyl group having 6 to 10 carbon atoms) is 50 to 91 mol% based on the entire monomer component.

6. The dicing die-bonding film according to claim 5,
wherein the content of the monomer exemplified by a chemical formula CH₂=CHCOOR (in the formula, R is an alkyl group having 6 to 10 carbon atoms) is 2-ethylhexylacrylate or isooctylacrylate.

7. The dicing die-bonding film according to claim 3,
wherein the acryl polymer contains a hydroxyl group-containing monomer copolymerizable with the acrylate as an essential component.

8. The dicing die-bonding film according to claim 7,
wherein the content of the hydroxyl group-containing monomer is in a range of 10 to 30 mol% based on the acrylate.

9. The dicing die-bonding film according to any of claims 1 to 8,
wherein the weight average molecular weight of the acryl polymer is 350,000 to 1,000,000

10. The dicing die-bonding film according to any of claims 1 to 9,
wherein the tensile elastic modulus of the pressure sensitive adhesive layer at 23 °C before radiation irradiation is in a range of 0.4 to 3.5 MPa, and the tensile elastic modulus at 23 °C after radiation irradiation is in a range of 7 to 100 MPa.

11. The dicing die-bonding film according to any of claims 1 to 10,
wherein the pressure sensitive adhesive layer contains a crosslinking agent having two or more functional groups showing reactivity to a hydroxyl group in the molecule.

12. The dicing die-bonding film according to claim 11,
wherein the crosslinking agent is at least one type selected from the group consisting of an isocyanate based crosslinking agent, an epoxy based crosslinking agent, an aziridine based crosslinking agent, and a melamine based crosslinking agent.
